# EUROPEAN PATENT APPLICATION

(11) **EP 4 803 975 A1**
(43) Date of publication of application: **09.09.2026**
(21) Application number: 25740661.1
(22) Date of filing: 12.06.2025
(51) Int. Cl.: G06F 1/18, H05K 7/14

(54) **SERVER CHASSIS MODULE**

(30) Priority: 30.12.2024 CN 202411973566
(71) Applicant: Suzhou Metabrain Intelligent Technology Co., Ltd., Suzhou, Jiangsu 215000 (CN)
(72) Inventor: ZHANG, Rufeng, Suzhou, Jiangsu 215000 (CN); NIU, Zhanlin, Suzhou, Jiangsu 215000 (CN); WEN, Xuanying, Suzhou, Jiangsu 215000 (CN)
(74) Representative: Studio Torta S.p.A.
(86) International application number: PCT/CN2025/100743
(87) International publication number: WO 2026/144000

(57) **Abstract**

Disposed in the present application is a server chassis module, including a chassis base and a mainboard tray. The chassis base is disposed with a bearing groove, and a bridge-shaped convex structure is disposed on a groove bottom surface of the bearing groove; a through hole structure is disposed at a position of the mainboard tray that is opposite to the bridge-shaped convex structure; and the bridge-shaped convex structure is mated with the through hole structure to connect the mainboard tray and the chassis base. The present application solves the problem that a connection mode between a mainboard tray and a chassis base may not ensure assembly convenience between the mainboard tray and the chassis base in the related art.

## Description

### Cross-Reference to Related Application

This present application claims priority to Chinese Patent Application No. 202411973566.2 filed to the China National Intellectual Property Administration on December 30, 2024 and entitled "Server Chassis Module", the application of which is hereby incorporated by reference in its entirety.

### Technical Field

The present application relates to the technical field of computers, and in particular, to a server chassis module.

### Background

In the related art, a mainboard tray is disposed on a chassis base of a server chassis module, and a mainboard is disposed on the mainboard tray, such that the mainboard is fixed on the chassis base. However, a connection between the related mainboard tray and the chassis base is realized through cooperation of a screw and a riveting stud and cooperation of a push pin and a hardy hole, that is, the connection mode between the related mainboard tray and the chassis base may not ensure assembly convenience between the mainboard tray and the chassis base.

### Summary

The present application is mainly intended to provide a server chassis module, so as to solve the problem that a connection mode between a mainboard tray and a chassis base may not ensure assembly convenience between the mainboard tray and the chassis base in the related art.

Some embodiments of the present application provide a server chassis module, including a chassis base and a mainboard tray. The chassis base is disposed with a bearing groove, and a bridge-shaped convex structure is disposed on a groove bottom surface of the bearing groove; a through hole structure is disposed at a position of the mainboard tray that is opposite to the bridge-shaped convex structure; and the bridge-shaped convex structure is mated with the through hole structure to connect the mainboard tray and the chassis base.

In some embodiments, in a direction from a front window to a rear window of the server chassis module, the bridge-shaped convex structure includes, in sequence, a first bridge-shaped convex segment, a second bridge-shaped convex segment, and a third bridge-shaped convex segment, which are connected to each other; the first bridge-shaped convex segment extends upward obliquely, the second bridge-shaped convex segment extends in a horizontal direction, and the third bridge-shaped convex segment extends downward obliquely; a width of at least a portion of the second bridge-shaped convex segment is greater than a width of the first bridge-shaped convex segment, and the width of at least the portion of the second bridge-shaped convex segment is greater than a width of the third bridge-shaped convex segment; in the direction from the front window to the rear window of the server chassis module, the through hole structure includes, in sequence, a first sub limiting hole segment, a second sub limiting hole segment, and a third sub limiting hole segment, which communicate with each other, and a width of the first sub limiting hole segment is greater than a width of the third sub limiting hole segment; the second sub limiting hole segment is conical; a large end side of the second sub limiting hole segment communicates with the first sub limiting hole segment, and a small end side of the second sub limiting hole segment communicates with the third sub limiting hole segment; and the width of at least the portion of the second bridge-shaped convex segment is less than the width of the first sub limiting hole segment, and the width of at least the portion of the second bridge-shaped convex segment is greater than the width of the third sub limiting hole segment.

In some embodiments, a first protruding structure is also disposed on the groove bottom surface of the bearing groove; the first protruding structure is disposed with a first assembly hole; a second protruding structure is disposed on the mainboard tray; the second protruding structure is disposed with a second assembly hole; and the server chassis module further includes a first fastening member, and the first fastening member sequentially passes through the second assembly hole and the first assembly hole, so as to connect the mainboard tray and the chassis base.

In some embodiments, a first limiting protrusion is disposed on a groove wall surface of the bearing groove in a protruding manner, and a side, facing toward the groove bottom surface of the bearing groove, of the first limiting protrusion is disposed with a first stopping surface; and a limiting flange is disposed at an outer periphery of the mainboard tray in a protruding manner, and after the mainboard tray is mounted on the chassis base, the first stopping surface and the limiting flange are in stopping fit to restrain the mainboard tray from moving toward a side away from a groove bottom of the bearing groove.

In some embodiments, the first stopping surface is flat; and/or a plurality of first limiting protrusions are disposed, at least two first limiting protrusions among the plurality of first limiting protrusions are respectively located at two opposite groove wall surfaces of the bearing groove, a plurality of limiting flanges are disposed, at least two first limiting protrusions among the plurality of limiting flanges are respectively located on two opposite side edges of the mainboard tray, and the plurality of limiting flanges correspond to the plurality of first limiting protrusions on a one-to-one basis; and/or in a direction from a front window to a rear window of the server chassis module, an extending length of the first limiting protrusion is less than an extending length of the limiting flange.

In some embodiments, wire management protrusions are disposed on a groove wall surface of the bearing groove, at least two wire management protrusions are disposed, distances of the at least two wire management protrusions from the groove bottom surface of the bearing groove are equal, and the at least two wire management protrusions are arranged at intervals in a direction from a front window to a rear window of the server chassis module. The server chassis module further includes a mainboard body and a memory module. The mainboard body is disposed on the mainboard tray. The memory module is disposed on the mainboard body and extending in the direction from the front window to the rear window of the server chassis module; and the memory module has a memory partition plate, and a wire management channel is formed between the memory partition plate and the at least two wire management protrusions.

In some embodiments, a first limiting protrusion is disposed on a groove wall surface of the bearing groove in a protruding manner, and a side, facing toward the groove bottom surface of the bearing groove, of the first limiting protrusion is disposed with a first stopping surface; a limiting flange is disposed at an outer periphery of the mainboard tray in a protruding manner, and after the mainboard tray is mounted on the chassis base, the first stopping surface and the limiting flange are in stopping fit to restrain the mainboard tray from moving toward a side away from a groove bottom of the bearing groove; a second limiting protrusion is also disposed on the groove wall surface of the bearing groove in a protruding manner, and a side, facing toward the rear window of the server chassis module, of the second limiting protrusion is disposed with a second stopping surface; a stop structure is disposed at the outer periphery of the mainboard tray; in the direction from the front window to the rear window of the server chassis module, the stop structure includes, in sequence, a first stop flange, a groove structure, and a second stop flange, which are connected to each other; after the mainboard tray is mounted on the chassis base, the second limiting protrusion is located at the groove structure, and the second stopping surface and a groove wall surface of the groove structure are in stopping fit to restrain the mainboard tray from moving toward a side of the rear window of the server chassis module; and each of the wire management protrusions is located between the first limiting protrusion and the second limiting protrusion, and a first distance H1 between each of the wire management protrusions and the groove bottom surface of the bearing groove, a second distance H2 between the first limiting protrusion and the groove bottom surface of the bearing groove, and a third distance H3 between the second limiting protrusion and the groove bottom surface of the bearing groove meet: H1>H2, and H1>H3.

In some embodiments, a first support bump is disposed on the groove bottom surface of the bearing groove in a protruding manner; a first avoidance through hole is disposed at a position of the mainboard tray that is opposite to the first support bump, so as to avoid the first support bump; the server chassis module further includes a mainboard body, and the mainboard body is disposed on the mainboard tray; a Central Processing Unit (CPU) module is also disposed on the mainboard tray; and the first support bump is configured to provide support for the CPU module.

In some embodiments, the server chassis module further includes an upper chassis cover; the upper chassis cove is disposed at a notch of the bearing groove and forms an accommodating cavity with the bearing groove; and a shielding protrusion is disposed on a sidewall surface of the chassis base in a protruding manner, and the shielding protrusion is in contact with an inner wall surface of the upper chassis cover to connect the chassis base and the upper chassis cover.

In some embodiments, a third protruding structure is disposed on the mainboard tray, and the third protruding structure is disposed with a third assembly hole. The server chassis module further includes the mainboard body and a second fastening member; a fourth assembly hole is disposed at a position of the mainboard body that is opposite to the third protruding structure; and the second fastening member sequentially passes through the fourth assembly hole and the third assembly hole to connect the mainboard body and the mainboard tray.

In some embodiments, a plurality of second support bumps are disposed on the mainboard tray in a protruding manner; and the plurality of second support bumps are arranged at intervals in length and width directions of the mainboard tray, so as to provide support for the mainboard body.

In some embodiments, at least two positioning posts are disposed on the mainboard tray in a protruding manner, and the mainboard body is disposed with at least two sliding positioning holes; the number of the at least two sliding positioning holes is the same as the number of the at least two positioning posts, and the at least two sliding positioning holes correspond to and are mated with the at least two positioning posts on a one-to-one basis; and the mainboard body is mounted on the mainboard tray through cooperative positioning of the at least two sliding positioning holes and the at least two positioning posts.

In some embodiments, the server chassis module further includes a support bracket. The support bracket is disposed on the mainboard body; a side, facing toward the front window of the server chassis module, of the support bracket is disposed with a support region, and the support region is configured to support a server module; a first positioning stud is disposed on the mainboard body in a protruding manner, and the first positioning stud has a first internal thread structure; and a first assembly lug is disposed on a side of the support bracket that faces toward the rear window of the server chassis module, the first assembly lug extends in a horizontal direction, and a second avoidance through hole is disposed on the first assembly lug. The server chassis module further includes a hand-turned screw. The hand-turned screw has a first external thread structure, passes through the second avoidance through hole, and is in threaded cooperation with the first internal thread structure.

In some embodiments, a second assembly lug is disposed on a side of the support bracket that faces toward the front window of the server chassis module, the second assembly lug extends in the horizontal direction, and a third avoidance through hole is disposed on the second assembly lug; a fourth protruding structure is disposed on the mainboard tray, the fourth protruding structure is disposed with a fifth assembly hole, and a hole wall surface of the fifth assembly hole has a second internal thread structure; and a sixth assembly hole is disposed at a position of the mainboard body that is opposite to the fifth assembly hole. The server chassis module further includes a second positioning stud. In a direction from a groove bottom of the bearing groove to a notch of the bearing groove, the second positioning stud includes, in sequence, a first shaft segment, a second shaft segment, and a third shaft segment, which are connected to each other; at least a portion of the first shaft segment has a second external thread structure that is configured to be mated with the second internal thread structure; a diameter of the second shaft segment is greater than a diameter of the first shaft segment, so as to form a first stopping ring surface at a junction of the first shaft segment and the second shaft segment; the first shaft segment passes through the sixth assembly hole and extends into the fifth assembly hole such that the first stopping ring surface abuts against the mainboard body; the diameter of the second shaft segment is greater than a diameter of the third shaft segment, so as to form a second stopping ring surface at a junction of the second shaft segment and the third shaft segment; and the third shaft segment passes through the third avoidance through hole such that the second stopping ring surface abuts against a surface of a side of the second assembly lug that faces toward the mainboard body.

In some embodiments, a limiting boss is also disposed on the second assembly lug, the limiting boss is disposed with a fourth avoidance through hole, and the fourth avoidance through hole and the third avoidance through hole are concentrically arranged; and the third shaft segment passes through the third avoidance through hole and extends into the fourth avoidance through hole.

In some embodiments, an avoidance notch is disposed on a side of the support bracket that faces toward the mainboard body; and at least two handle grooves are disposed at the avoidance notch.

In some embodiments, a wire management buckle is disposed on two sides of the support bracket in a width direction of the chassis base; a first end of the wire management buckle is connected to a sidewall surface of the support bracket; and a second end of the wire management buckle first extends in the horizontal direction for a first preset distance, then obliquely extends upward in a direction away from the support bracket for a second preset distance, and continuously obliquely extends upward in a direction close to the support bracket for a third preset distance.

In some embodiments, the mainboard tray includes a tray body and a guiding flange. The through hole structure is a limiting hole that is disposed on the tray body; and the guiding flange is disposed at a hole periphery of at least a portion of the limiting hole, and the guiding flange extends in a direction away from the tray body.

In some embodiments, a second limiting protrusion is disposed on a groove wall surface of the bearing groove in a protruding manner, and a side, facing toward a rear window of the server chassis module, of the second limiting protrusion is disposed with a second stopping surface; a stop structure is disposed at an outer periphery of the mainboard tray; in a direction from a front window to the rear window of the server chassis module, the stop structure includes, in sequence, a first stop flange, a groove structure, and a second stop flange, which are connected to each other; and after the mainboard tray is mounted on the chassis base, the second limiting protrusion is located at the groove structure, and the second stopping surface and a groove wall surface of the groove structure are in stopping fit to restrain the mainboard tray from moving toward a side of the rear window of the server chassis module.

In some embodiments, wire management protrusions are disposed on a groove wall surface of the bearing groove, at least two wire management protrusions are disposed, distances of the at least two wire management protrusions from the groove bottom surface of the bearing groove are equal, and the at least two wire management protrusions are arranged at intervals in a direction from a front window to a rear window of the server chassis module; and a limiting groove is disposed in a surface of a side of each of the wire management protrusions that is away from the groove bottom surface of the bearing groove. The server chassis module further includes a mainboard body and a memory module. The mainboard body is disposed on the mainboard tray; the memory module is disposed on the mainboard body and extends in the direction from the front window to the rear window of the server chassis module; and the memory module has a memory partition plate. The memory module further includes a flipping cover plate. The flipping cover plate is pivotally connected to a side of the memory partition plate that is away from the mainboard body, where the flipping cover plate is at least flipped to a horizontal state such that the flipping cover plate, the memory partition plate, and the groove wall surface of the bearing groove form a wire management channel. A lug structure is disposed on an edge of a side of the flipping cover plate that is away from the memory partition plate, the lug structure is disposed with a limiting protrusion in a protruding manner on a side facing toward the groove bottom surface of the bearing groove, and when the flipping cover plate is flipped to the horizontal state, the limiting protrusion extends into the limiting groove.

In some embodiments, an avoidance groove is disposed in the edge of the side of the flipping cover plate that is away from the memory partition plate; the memory module further includes a handle structure; the handle structure is disposed at the avoidance groove, and the handle structure and the flipping cover plate are arranged at an angle to each other; and the handle structure obliquely extends upward along the groove wall surface of the bearing groove.

In some embodiments, a torsional spring is further disposed at a pivoted junction between the flipping cover plate and the memory partition plate; and the torsional spring is configured to provide an elastic force for the flipping cover plate to flip to the horizontal state.

By using the technical solutions of the present application, the server chassis module is disposed and includes the chassis base and the mainboard tray. The chassis base is disposed with the bearing groove, and the bridge-shaped convex structure is disposed on the groove bottom surface of the bearing groove; the through hole structure is disposed at the position of the mainboard tray that is opposite to the bridge-shaped convex structure; and the bridge-shaped convex structure is mated with the through hole structure to connect the mainboard tray and the chassis base. In this way, the mainboard tray is positioned and mounted on the chassis base through the cooperation of the bridge-shaped convex structure and the through hole structure. Compared to the cooperation of an existing push pin and a hardy hole, a contact area between the bridge-shaped convex structure and the through hole structure is larger, such that assembly efficiency between the mainboard tray and the chassis base is improved, and the mainboard tray and the chassis base are conveniently disassembled, thereby greatly improving the convenience of disassembly and assembly between the mainboard tray and the chassis base.

### Brief Description of the Drawings

The drawings described herein are used to provide a further understanding of the present application, and constitute a part of the present application. The specific embodiments and descriptions of the present application are used to explain the present application and do not constitute an improper limitation of the present application. In the drawings:
Fig. 1 is a schematic diagram of partial structures of a server chassis module according to an embodiment of the present application.
Fig. 2 is a schematic diagram of an enlarged structure of A in Fig. 1.
Fig. 3 is a schematic diagram of an enlarged structure of B in Fig. 1.
Fig. 4 is a schematic diagram of an enlarged structure of C in Fig. 1.
Fig. 5 is a schematic diagram of an enlarged structure of D in Fig. 1.
Fig. 6 is a schematic structural diagram of a chassis base of the server chassis module in Fig. 1.
Fig. 7 is a schematic diagram of an enlarged structure of E in Fig. 6.
Fig. 8 is a schematic diagram of an enlarged structure of F in Fig. 6.
Fig. 9 is a schematic structural diagram of a mainboard tray of the server chassis module in Fig. 1.
Fig. 10 is a schematic diagram of an enlarged structure of G in Fig. 9.
Fig. 11 is a schematic structural diagram of a server chassis module in a top view according to an embodiment of the present application.
Fig. 12 is a schematic diagram of an enlarged structure of H in Fig. 11.
Fig. 13 is a schematic diagram of an enlarged structure of K in Fig. 11.
Fig. 14 is a schematic diagram of partial structures of a wire management channel formed between a memory partition plate of a memory module and a groove wall surface of a bearing groove of a server chassis module according to an embodiment of the present application.
Fig. 15 is a schematic diagram of partial structures of a wire management channel formed between a memory module and a groove wall surface of a bearing groove of a server chassis module according to an embodiment of the present application.
Fig. 16 is a schematic structural diagram of the memory module in Fig. 15.
Fig. 17 is a schematic structural diagram of a top view when a second limiting protrusion and a stop structure are in a stop state in Fig. 4.
Fig. 18 is a schematic diagram of partial structures of a support bracket of the server chassis module mounted on a mainboard body in Fig.11.
Fig. 19 is a schematic structural diagram of the support bracket in Fig. 18.
Fig. 20 is a schematic structural diagram of a front view of the support bracket mounted on the mainboard body in Fig. 18.
Fig. 21 is a schematic diagram of an enlarged structure of M in Fig. 20.

The above drawings include the following reference numerals:
10. Chassis base; 11. Bearing groove; 111. First protruding structure; 1111. First assembly hole; 112. First limiting protrusion; 113. Second limiting protrusion; 12. Bridge-shaped convex structure; 121. First bridge-shaped convex segment; 122. Second bridge-shaped convex segment; 123. Third bridge-shaped convex segment; 13. Wire management protrusion; 131. Limiting groove; 14. First support bump; 15. Shielding protrusion;
20. Mainboard tray; 21. Through hole structure; 211. First sub limiting hole segment; 212. Second sub limiting hole segment; 213. Third sub limiting hole segment; 22. Tray body; 23. Guiding flange; 24. Second protruding structure; 241. Second assembly hole; 25. Limiting flange; 26. Stop structure; 261. First stop flange; 262. Groove structure; 263. Second stop flange; 27. First avoidance through hole; 28. Third protruding structure; 281. Third assembly hole; 29. Second support bump; 210. Positioning post; 220. Fourth protruding structure; 2201. Fifth assembly hole;
30. Mainboard body; 31. Sliding positioning hole; 32. First positioning stud;
40. Memory module; 41. Memory partition plate; 42. Flipping cover plate; 421. Lug structure; 4211. Limiting protrusion; 422. Avoidance groove; 43. Handle structure;
50. CPU module;
60. Support bracket; 61. First assembly lug; 62. Second assembly lug; 63. Limiting boss; 631. Fourth avoidance through hole; 64. Avoidance notch; 641. Handle groove; 65. Wire management buckle;
70. Server module; 80. Hand-turned screw;
90. Second positioning stud; 91. First shaft segment; 92. Second shaft segment; 93. Third shaft segment;
100. Wire management channel.

### Detailed Description of the Embodiments

It is to be noted that the embodiments in the present application and the features in the embodiments may be combined with one another without conflict. The present application will be described below in detail with reference to the drawings and the embodiments.

The technical solutions in the embodiments of the present application will be clearly and completely described below in combination with the drawings in the embodiments of the present application. It is apparent that the described embodiments are only part of the embodiments of the present application, not all the embodiments. The following description of at least one specific embodiment is merely illustrative in nature and is never intended to limit the present application and application or use thereof in any way. All other embodiments obtained by those of ordinary skill in the art on the basis of the embodiments in the present application without creative work all fall within the scope of protection of the present application.

In order to solve the problem that a connection mode between a mainboard tray and a chassis base may not ensure assembly convenience between the mainboard tray and the chassis base in the related art, the present application provides a server chassis module.

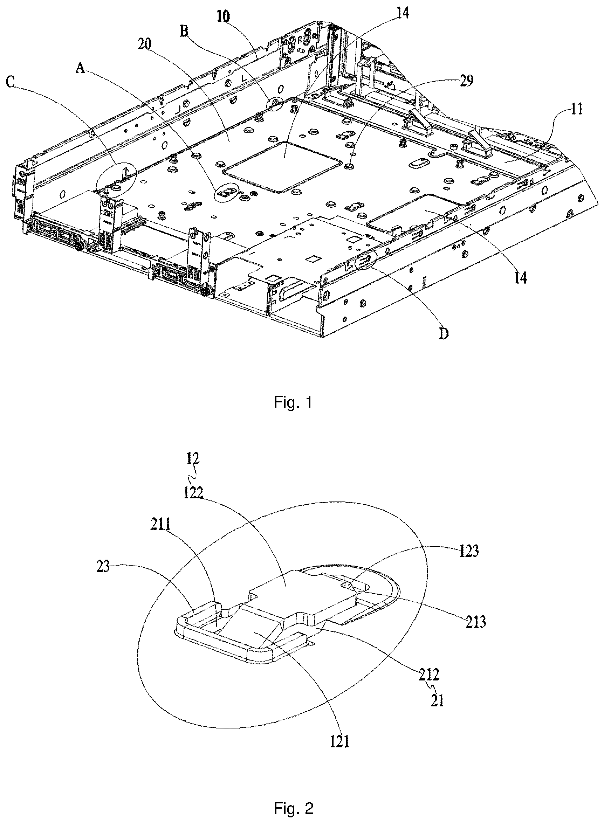

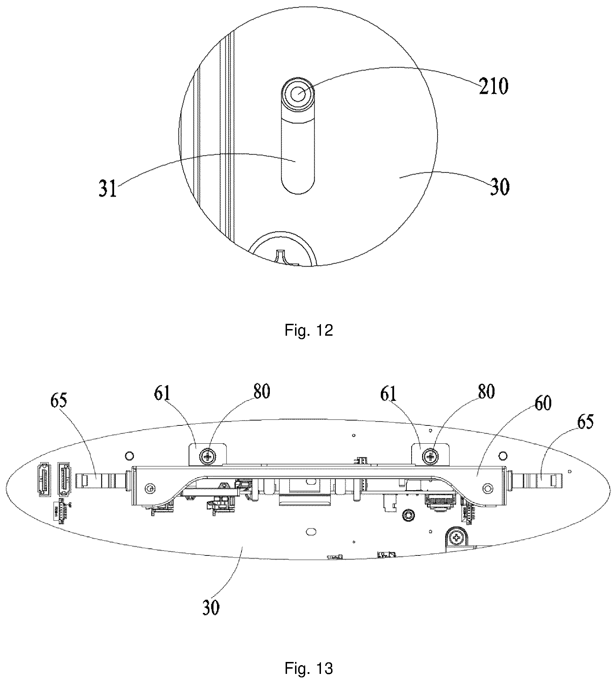

As shown in Figs. 1 to 21, the server chassis module includes a chassis base 10 and a mainboard tray 20. The chassis base 10 is disposed with a bearing groove 11, and a bridge-shaped convex structure 12 is disposed on a groove bottom surface of the bearing groove 11; a through hole structure 21 is disposed at a position of the mainboard tray 20 that is opposite to the bridge-shaped convex structure 12; and the bridge-shaped convex structure 12 is mated with the through hole structure 21 to connect the mainboard tray 20 and the chassis base 10.

By using the technical solutions of the present application, the server chassis module is disposed and includes the chassis base 10 and the mainboard tray 20. The chassis base 10 is disposed with the bearing groove 11, and the bridge-shaped convex structure 12 is disposed on the groove bottom surface of the bearing groove 11; the through hole structure 21 is disposed at the position of the mainboard tray 20 that is opposite to the bridge-shaped convex structure 12; and the bridge-shaped convex structure 12 is mated with the through hole structure 21 to connect the mainboard tray 20 and the chassis base 10. In this way, the mainboard tray 20 is positioned and mounted on the chassis base 10 through the cooperation of the bridge-shaped convex structure 12 and the through hole structure 21. Compared to the cooperation of an existing push pin and a hardy hole, a contact area between the bridge-shaped convex structure 12 and the through hole structure 21 is larger, such that assembly efficiency between the mainboard tray 20 and the chassis base 10 is improved, and the mainboard tray 20 and the chassis base 10 are conveniently disassembled, thereby greatly improving the convenience of disassembly and assembly between the mainboard tray 20 and the chassis base 10.

As shown in Fig. 1, Fig. 2, Fig. 9, and Fig. 10, in a direction from a front window to a rear window of the server chassis module, the bridge-shaped convex structure 12 includes, in sequence, a first bridge-shaped convex segment 121, a second bridge-shaped convex segment 122, and a third bridge-shaped convex segment 123, which are connected to each other; the first bridge-shaped convex segment 121 extends upward obliquely, the second bridge-shaped convex segment 122 extends in a horizontal direction, and the third bridge-shaped convex segment 123 extends downward obliquely; a width of at least a portion of the second bridge-shaped convex segment 122 is greater than a width of the first bridge-shaped convex segment 121, and the width of at least the portion of the second bridge-shaped convex segment 122 is greater than a width of the third bridge-shaped convex segment 123; in the direction from the front window to the rear window of the server chassis module, the through hole structure 21 includes, in sequence, a first sub limiting hole segment 211, a second sub limiting hole segment 212, and a third sub limiting hole segment 213, which communicate with each other, and a width of the first sub limiting hole segment 211 is greater than a width of the third sub limiting hole segment 213; the second sub limiting hole segment 212 is conical; a large end side of the second sub limiting hole segment 212 communicates with the first sub limiting hole segment 211, and a small end side of the second sub limiting hole segment 212 communicates with the third sub limiting hole segment 213; and the width of at least the portion of the second bridge-shaped convex segment 122 is less than the width of the first sub limiting hole segment 211, and the width of at least the portion of the second bridge-shaped convex segment 122 is greater than the width of the third sub limiting hole segment 213. In this way, by configuring the bridge-shaped convex structure 12 to a structural form of including, in sequence, the first bridge-shaped convex segment 121, the second bridge-shaped convex segment 122, and the third bridge-shaped convex segment 123, which are connected to each other, and configuring the through hole structure 21 to a structural form of including, in sequence, the first sub limiting hole segment 211, the second sub limiting hole segment 212, and the third sub limiting hole segment 213, which communicate with each other, the assembly convenience of the bridge-shaped convex structure 12 and the through hole structure 21 is ensured, and the mainboard tray 20 is rapidly mounted on the chassis base 10, thereby improving the assembly efficiency of the mainboard tray 20 and the chassis base 10. During assembly, the second bridge-shaped convex segment 122 of the bridge-shaped convex structure 12 needs to pass through the first sub limiting hole segment 211, and then the mainboard tray 20 is slid in a preset direction, such that the second bridge-shaped convex segment 122 abuts against and is in lap joint with the second sub limiting hole segment 212 and the third sub limiting hole segment 213.

It is to be noted that, in the present application, the stamping forming of the bridge-shaped convex structure 12 facilitates the reduction of the processing and manufacturing costs of the server chassis module. Furthermore, compared to the cooperation of an existing push pin and a hardy hole, a contact area between the bridge-shaped convex structure 12 and the through hole structure 21 is larger, such that assembly efficiency between the mainboard tray 20 and the chassis base 10 is improved, and the mainboard tray 20 and the chassis base 10 are conveniently disassembled, thereby greatly improving the convenience of disassembly and assembly between the mainboard tray 20 and the chassis base 10.

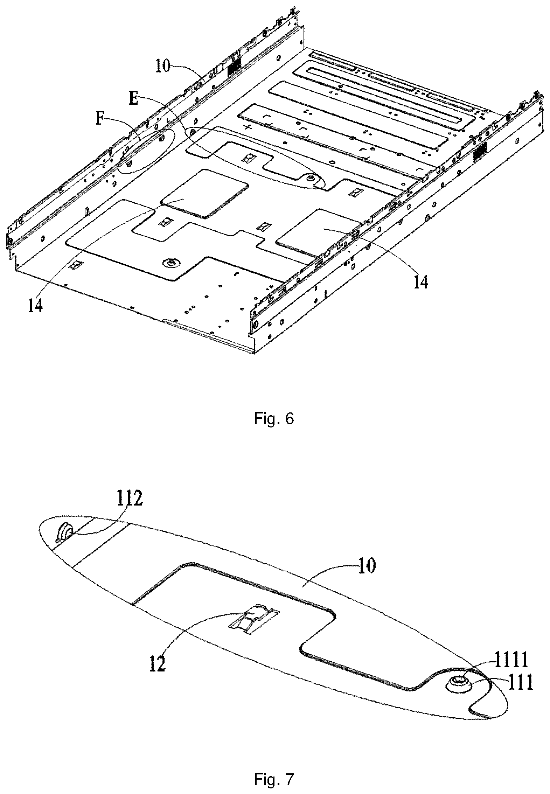

As shown in Fig. 6, Fig. 7, and Fig. 9, a first protruding structure 111 is also disposed on the groove bottom surface of the bearing groove 11; the first protruding structure 111 is disposed with a first assembly hole 1111; a second protruding structure 24 is disposed on the mainboard tray 20; the second protruding structure 24 is disposed with a second assembly hole 241; and the server chassis module further includes a first fastening member, and the first fastening member sequentially passes through the second assembly hole 241 and the first assembly hole 1111, so as to connect the mainboard tray 20 and the chassis base 10. In this way, the connection reliability of the mainboard tray 20 and the chassis base 10 is realized through the cooperation of the first fastening member and the first assembly hole 1111.

In some embodiments of the present application, the first fastening member has an external thread structure, and the first assembly hole 1111 has an internal thread structure, such that the first fastening member is in threaded connection with the first assembly hole 1111.

In some embodiments of the present application, the first protruding structure 111 is a two-superimposed protruding structure. In this way, the use of press riveting studs, the use of push pins, and riveting processes are reduced, thereby achieving high cost performance.

As shown in Fig. 1, Fig. 3, Fig. 6, Fig. 7, and Fig. 9, a first limiting protrusion 112 is disposed on a groove wall surface of the bearing groove 11 in a protruding manner, and a side, facing toward the groove bottom surface of the bearing groove 11, of the first limiting protrusion 112 is disposed with a first stopping surface; and a limiting flange 25 is disposed at an outer periphery of the mainboard tray 20 in a protruding manner, and after the mainboard tray 20 is mounted on the chassis base 10, the first stopping surface and the limiting flange 25 are in stopping fit to restrain the mainboard tray 20 from moving toward a side away from a groove bottom of the bearing groove 11. In this way, through the stopping fit of the first limiting protrusion 112 and the limiting flange 25, the effect of preventing the mainboard tray 20 from moving toward the side away from the groove bottom of the bearing groove 11 is achieved, such that the moving of the mainboard tray 20 from the groove bottom to the notch of the bearing groove 11 is restrained.

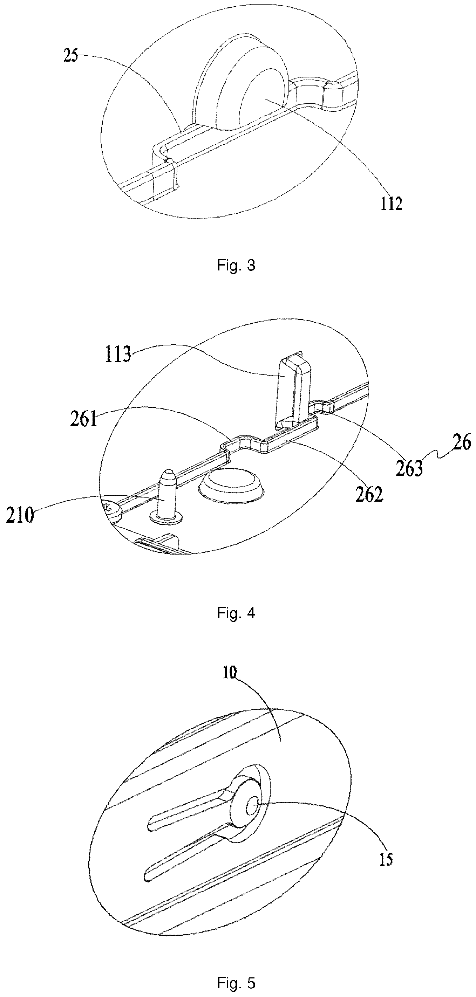

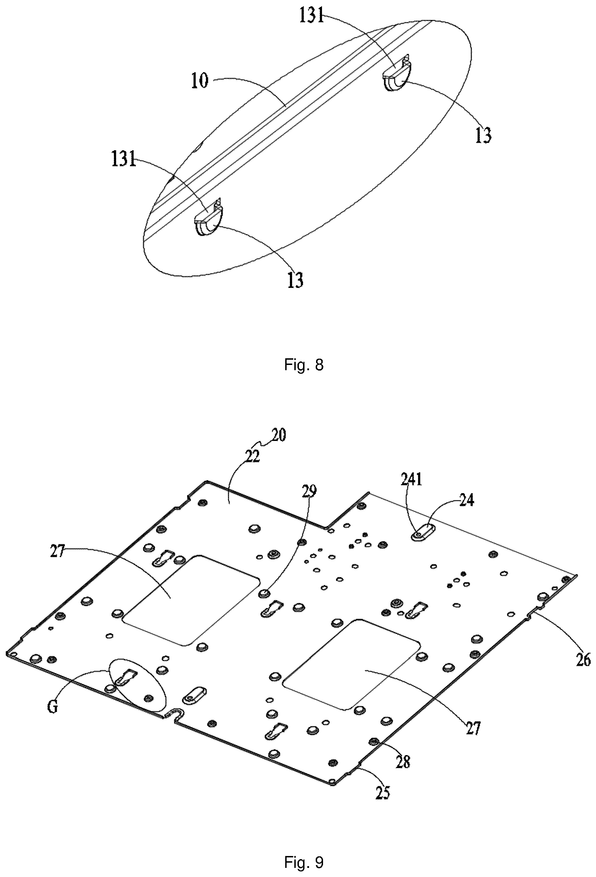

As shown in Fig. 3 and Fig. 9, the first stopping surface is flat; and/or a plurality of first limiting protrusions 112 are disposed, at least two first limiting protrusions 112 among the plurality of first limiting protrusions 112 are respectively located at two opposite groove wall surfaces of the bearing groove 11, a plurality of limiting flanges 25 are disposed, at least two first limiting protrusions 112 among the plurality of limiting flanges 25 are respectively located on two opposite side edges of the mainboard tray 20, and the plurality of limiting flanges 25 correspond to the plurality of first limiting protrusions 112 on a one-to-one basis; and/or in a direction from a front window to a rear window of the server chassis module, an extending length of the first limiting protrusion 112 is less than an extending length of the limiting flange 25. In this way, the first stopping surface is flat, such that a stopping fit area between the first stopping surface and the limiting flange 25 is increased. The plurality of first limiting protrusions 112 and the plurality of limiting flanges 25 are arranged, and at least two first limiting protrusions 112 among the plurality of first limiting protrusions 112 are respectively located at the two opposite groove wall surfaces of the bearing groove 11, such that while ensuring that the mainboard tray 20 and the chassis base 10 have a plurality of stop points, it is ensured to restrain the mainboard tray 20 from moving from the groove bottom to the notch of the bearing groove 11. The extending length of the first limiting protrusion 112 is less than the extending length of the limiting flange 25. Since the mainboard tray 20 needs to be mounted on the chassis base 10 in a sliding manner, prevention of the moving of the mainboard tray 20 causes the first limiting protrusion 112 and the limiting flange 25 to be unable to effectively achieve stopping fit.

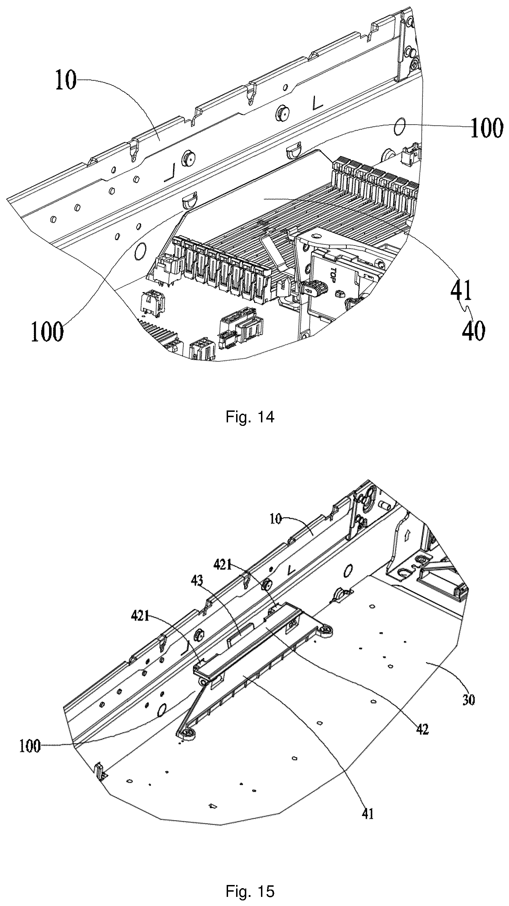

As shown in Fig. 14, wire management protrusions 13 are disposed on a groove wall surface of the bearing groove 11, at least two wire management protrusions 13 are disposed, distances of the at least two wire management protrusions 13 from the groove bottom surface of the bearing groove 11 are equal, and the at least two wire management protrusions 13 are arranged at intervals in a direction from a front window to a rear window of the server chassis module. The server chassis module further includes a mainboard body 30 and a memory module 40. The mainboard body 30 is disposed on the mainboard tray 20. The memory module 40 is disposed on the mainboard body 30 and extending in the direction from the front window to the rear window of the server chassis module; and the memory module 40 has a memory partition plate 41, and a wire management channel 100 is formed between the memory partition plate 41 and the at least two wire management protrusions 13. In this way, the constrained reliability of wires is ensured, it ensures that the entire layout is relatively regular, an additional wire management structure is not required, there are few spaces occupied, and fewer new molds are developed, thereby facilitating the reduction in the manufacturing cost of the server chassis module.

As shown in Fig. 1, Fig. 6, Fig. 8, and Fig. 17, a first limiting protrusion 112 is disposed on a groove wall surface of the bearing groove 11 in a protruding manner, and a side, facing toward the groove bottom surface of the bearing groove 11, of the first limiting protrusion 112 is disposed with a first stopping surface; a limiting flange 25 is disposed at an outer periphery of the mainboard tray 20 in a protruding manner, and after the mainboard tray 20 is mounted on the chassis base 10, the first stopping surface and the limiting flange 25 are in stopping fit to restrain the mainboard tray 20 from moving toward a side away from a groove bottom of the bearing groove 11; a second limiting protrusion 113 is also disposed on the groove wall surface of the bearing groove 11 in a protruding manner, and a side, facing toward the rear window of the server chassis module, of the second limiting protrusion 113 is disposed with a second stopping surface; a stop structure 26 is disposed at the outer periphery of the mainboard tray 20; in the direction from the front window to the rear window of the server chassis module, the stop structure 26 includes, in sequence, a first stop flange 261, a groove structure 262, and a second stop flange 263, which are connected to each other; after the mainboard tray 20 is mounted on the chassis base 10, the second limiting protrusion 113 is located at the groove structure 262, and the second stopping surface and a groove wall surface of the groove structure 262 are in stopping fit to restrain the mainboard tray 20 from moving toward a side of the rear window of the server chassis module; and each of the wire management protrusions 13 is located between the first limiting protrusion 112 and the second limiting protrusion 113, and a first distance H1 between each of the wire management protrusions 13 and the groove bottom surface of the bearing groove 11, a second distance H2 between the first limiting protrusion 112 and the groove bottom surface of the bearing groove 11, and a third distance H3 between the second limiting protrusion 113 and the groove bottom surface of the bearing groove 11 meet: H1>H2, and H1> H3. In this way, the memory module 40 is ensured to be mounted in a space of the mainboard body 30 that is located between the first limiting protrusion 112 and the second limiting protrusion 113, such that the wire management channel 100 formed between the memory partition plate 41 and the at least two wire management protrusions 13 has enough space for wire management.

As shown in Fig. 1, Fig. 6, Fig. 9, and Fig. 11, a first support bump 14 is disposed on the groove bottom surface of the bearing groove 11 in a protruding manner; a first avoidance through hole 27 is disposed at a position of the mainboard tray 20 that is opposite to the first support bump 14, so as to avoid the first support bump 14; the server chassis module further includes a mainboard body 30, and the mainboard body 30 is disposed on the mainboard tray 20; a Central Processing Unit (CPU) module 50 is also disposed on the mainboard tray 20; and the first support bump 14 is configured to provide support for the CPU module 50. In this way, the support reliability of the CPU module 50 is ensured, the chassis base 10 is thicker, and a support force is stronger, such that the risk of stress-strain deformation of the mainboard body 30 is reduced, thereby ensuring the reliability of the server chassis module.

As shown in Fig. 1 and Fig. 5, the server chassis module further includes an upper chassis cover; the upper chassis cove is disposed at a notch of the bearing groove 11 and forms an accommodating cavity with the bearing groove 11; and a shielding protrusion 15 is disposed on a sidewall surface of the chassis base 10 in a protruding manner, and the shielding protrusion 15 is in contact with an inner wall surface of the upper chassis cover to connect the chassis base 10 and the upper chassis cover. In this way, the purpose of electromagnetic shielding is achieved by connecting the chassis base 10 and the upper chassis cover.

As shown in Fig. 9 to Fig. 11, a third protruding structure 28 is disposed on the mainboard tray 20, and the third protruding structure 28 is disposed with a third assembly hole 281. The server chassis module further includes the mainboard body 30 and a second fastening member; a fourth assembly hole is disposed at a position of the mainboard body 30 that is opposite to the third protruding structure 28; and the second fastening member sequentially passes through the fourth assembly hole and the third assembly hole 281 to connect the mainboard body 30 and the mainboard tray 20. In this way, the mainboard body 30 and the mainboard tray 20 are connected through the cooperation of the second fastening member and the third assembly hole 281, such that the connection reliability between the mainboard body 30 and the mainboard tray 20 is ensured.

In some embodiments of the present application, the second fastening member has an external thread structure, and the third assembly hole 281 has an internal thread structure, such that the second fastening member is in threaded connection with the third assembly hole 281.

In some embodiments of the present application, the third protruding structure 28 is a bump sprout. In this way, the use of press riveting studs, the use of push pins, and riveting processes are reduced, thereby achieving high cost performance.

As shown in Fig. 9, a plurality of second support bumps 29 are disposed on the mainboard tray 20 in a protruding manner; and the plurality of second support bumps 29 are arranged at intervals in length and width directions of the mainboard tray 20, so as to provide support for the mainboard body 30. In this way, the mainboard body 30 is supported by arranging the plurality of second support bumps 29.

As shown in Fig. 1, Fig. 4, Fig. 11, and Fig. 12, at least two positioning posts 210 are also disposed on the mainboard tray 20 in a protruding manner, and the mainboard body 30 is disposed with at least two sliding positioning holes 31; the number of the sliding positioning holes 31 is the same as the number of the positioning posts 210, and the sliding positioning holes correspond to and are mated with the positioning posts on a one-to-one basis; and the mainboard body 30 is mounted on the mainboard tray 20 through cooperative positioning of the sliding positioning holes 31 and the positioning posts 210. In this way, the positioning reliability of the mainboard body 30 is achieved by arranging at least two positioning posts 210.

It is to be noted that, in the present application, a height of the positioning post 210 is greater than a height of the second support bump 29. In this way, the positioning post 210 is able to play a role in roughly positioning the mainboard body 30.

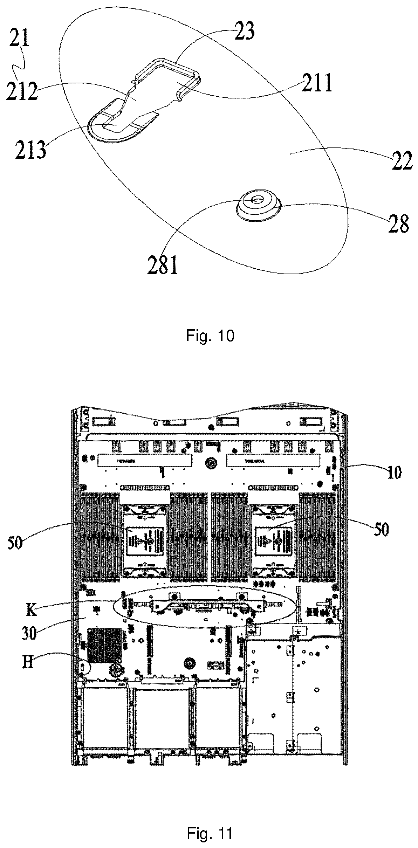

As shown in Fig. 11, Fig. 13, and Figs. 18 to 20, the server chassis module further includes a support bracket 60. The support bracket 60 is disposed on the mainboard body 30; a side, facing toward the front window of the server chassis module, of the support bracket 60 is disposed with a support region, and the support region is configured to support a server module 70; a first positioning stud 32 is disposed on the mainboard body 30 in a protruding manner, and the first positioning stud 32 has a first internal thread structure; and a first assembly lug 61 is disposed on a side of the support bracket 60 that faces toward the rear window of the server chassis module, the first assembly lug 61 extends in the horizontal direction, and a second avoidance through hole is disposed on the first assembly lug 61. The server chassis module further includes a hand-turned screw 80. The hand-turned screw 80 has a first external thread structure, passes through the second avoidance through hole, and is in threaded cooperation with the first internal thread structure. In this way, the support and limiting reliability of the first positioning stud 32 to the support bracket 60 is ensured, the mounting stability and mounting convenience of the support bracket 60 are ensured, and the support reliability of the support bracket 60 to the server module 70 is ensured, thereby fully using a limited space of the mainboard body 30.

In some embodiments of the present application, the server module 70 is an M.2 module, and the support bracket 60 is a bracket structure configured to support the M.2 module.

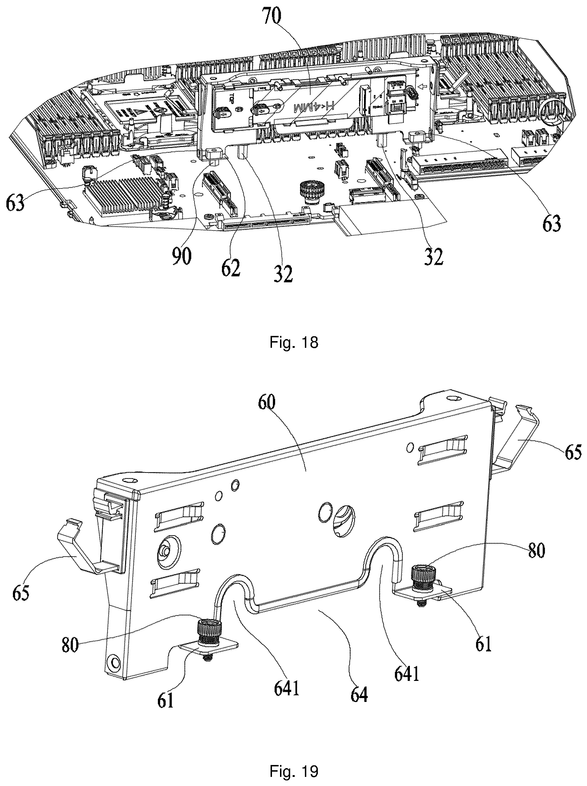

As shown in Fig. 18, Fig. 20, and Fig. 21, a second assembly lug 62 is disposed on a side of the support bracket 60 that faces toward the front window of the server chassis module, the second assembly lug 62 extends in the horizontal direction, and a third avoidance through hole is disposed on the second assembly lug 62; a fourth protruding structure 220 is disposed on the mainboard tray 20, the fourth protruding structure 220 is disposed with a fifth assembly hole 2201, and a hole wall surface of the fifth assembly hole 2201 has a second internal thread structure; and a sixth assembly hole is disposed at a position of the mainboard body 30 that is opposite to the fifth assembly hole 2201. The server chassis module further includes a second positioning stud 90. In a direction from the groove bottom to the notch of the bearing groove 11, the second positioning stud 90 includes, in sequence, a first shaft segment 91, a second shaft segment 92, and a third shaft segment 93, which are connected to each other; at least a portion of the first shaft segment 91 has a second external thread structure that is configured to be mated with the second internal thread structure; a diameter of the second shaft segment 92 is greater than a diameter of the first shaft segment 91, so as to form a first stopping ring surface at a junction of the first shaft segment and the second shaft segment; the first shaft segment 91 passes through the sixth assembly hole and extends into the fifth assembly hole 2201 such that the first stopping ring surface abuts against the mainboard body 30; the diameter of the second shaft segment 92 is greater than a diameter of the third shaft segment 93, so as to form a second stopping ring surface at a junction of the second shaft segment and the third shaft segment; and the third shaft segment 93 passes through the third avoidance through hole such that the second stopping ring surface abuts against a surface of a side of the second assembly lug 62 that faces toward the mainboard body 30. In this way, the mounting stability and mounting convenience of the support bracket 60 are ensured.

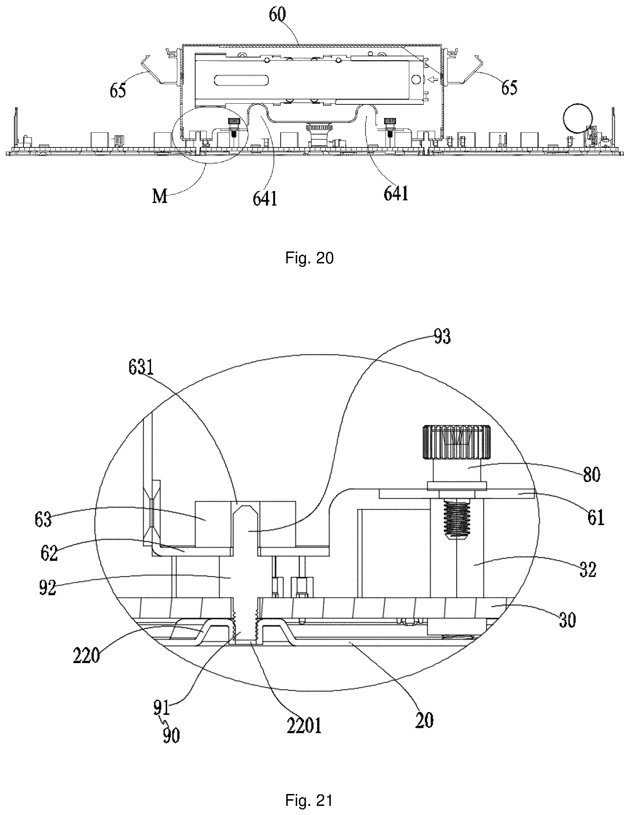

As shown in Fig. 21, a limiting boss 63 is also disposed on the second assembly lug 62, the limiting boss 63 is disposed with a fourth avoidance through hole 631, and the fourth avoidance through hole 631 and the third avoidance through hole are concentrically arranged; and the third shaft segment 93 passes through the third avoidance through hole and extends into the fourth avoidance through hole 631. In this way, the support and limiting reliability of the second positioning stud 90 to the support bracket 60 is ensured.

As shown in Fig. 19, an avoidance notch 64 is disposed on a side of the support bracket 60 that faces toward the mainboard body 30; and at least two handle grooves 641 are disposed at the avoidance notch 64. In this way, an operator conveniently puts his/her hand at the avoidance notch 64 to operate the mainboard body 30, and may use when lifting the mainboard body 30.

As shown in Fig. 19 and Fig. 20, two sides of the support bracket 60 in a width direction of the chassis base 10 have wire management buckles 65; a first end of a wire management buckle 65 is connected to a sidewall surface of the support bracket 60; and a second end of the wire management buckle 65 first extends in the horizontal direction for a first preset distance, then obliquely extends upward in a direction away from the support bracket 60 for a second preset distance, and continuously obliquely extends upward in a direction close to the support bracket 60 for a third preset distance. In this way, through the arrangement of the wire management buckle 65, the wires are supported and limited.

As shown in Fig. 2 and Fig. 10, the mainboard tray 20 includes a tray body 22 and a guiding flange 23. The through hole structure 21 is a limiting hole that is disposed on the tray body 22; and the guiding flange 23 is disposed at a hole periphery of at least a portion of the limiting hole, and the guiding flange 23 extends in a direction away from the tray body 22. In this way, through the arrangement of the guiding flange 23, when the through hole structure 21 and the bridge-shaped convex structure 12 are assembled, wear on the hole edge of the through hole structure 21 and even the occurrence of the falling of iron filings are prevented.

As shown in Fig. 2 and Fig. 10, in the direction from the front window to the rear window of the server chassis module, the through hole structure 21 includes, in sequence, a first sub limiting hole segment 211, a second sub limiting hole segment 212, and a third sub limiting hole segment 213, which communicate with each other, and a width of the first sub limiting hole segment 211 is greater than a width of the third sub limiting hole segment 213; the second sub limiting hole segment 212 is conical; a large end side of the second sub limiting hole segment 212 communicates with the first sub limiting hole segment 211, and a small end side of the second sub limiting hole segment 212 communicates with the third sub limiting hole segment 213; and the guiding flange 23 is disposed at the hole periphery of at least a portion of the first sub limiting hole segment 211.

As shown in Fig. 1, Fig. 4, and Fig. 17, a second limiting protrusion 113 is disposed on a groove wall surface of the bearing groove 11 in a protruding manner, and a side, facing toward a rear window of the server chassis module, of the second limiting protrusion 113 is disposed with a second stopping surface; a stop structure 26 is disposed at an outer periphery of the mainboard tray 20; in a direction from a front window to the rear window of the server chassis module, the stop structure 26 includes, in sequence, a first stop flange 261, a groove structure 262, and a second stop flange 263, which are connected to each other; and after the mainboard tray 20 is mounted on the chassis base 10, the second limiting protrusion 113 is located at the groove structure 262, and the second stopping surface and a groove wall surface of the groove structure 262 are in stopping fit to restrain the mainboard tray 20 from moving toward a side of the rear window of the server chassis module. In this way, the second limiting protrusion 113 is mated with the stop structure 26, such that the mainboard tray 20 is limited in the direction from the front window to the rear window of the server chassis module.

It is to be noted that, in the present application, considering that the mainboard tray 20 is mounted on the chassis base 10 in a sliding manner, in order to ensure that the second limiting protrusion 113 is able to be mounted in place by sliding a preset distance along the groove structure 262, in some embodiments of the present application, the second stopping surface is flat; and/or in the direction from the front window to the rear window of the server chassis module, an extending length of the second limiting protrusion 113 is less than an extending length of the groove structure 262.

As shown in Fig. 6, Fig. 8, Fig. 15, and Fig. 16, wire management protrusions 13 are disposed on a groove wall surface of the bearing groove 11, at least two wire management protrusions 13 are disposed, distances of the at least two wire management protrusions 13 from the groove bottom surface of the bearing groove 11 are equal, and the at least two wire management protrusions 13 are arranged at intervals in a direction from a front window to a rear window of the server chassis module; and a limiting groove 131 is disposed in a surface of a side of each of the wire management protrusions 13 that is away from the groove bottom surface of the bearing groove 11. The server chassis module further includes a mainboard body 30 and a memory module 40. The mainboard body 30 is disposed on the mainboard tray 20; the memory module 40 is disposed on the mainboard body 30 and extends in the direction from the front window to the rear window of the server chassis module; and the memory module 40 has a memory partition plate 41. The memory module 40 further includes a flipping cover plate 42. The flipping cover plate 42 is pivotally connected to a side of the memory partition plate 41 that is away from the mainboard body 30, where the flipping cover plate 42 is at least flipped to a horizontal state such that the flipping cover plate 42, the memory partition plate 41, and the groove wall surface of the bearing groove 11 form a wire management channel 100. A lug structure 421 is disposed on an edge of a side of the flipping cover plate 42 that is away from the memory partition plate 41, the lug structure 421 is disposed with a limiting protrusion 4211 in a protruding manner on a side facing toward the groove bottom surface of the bearing groove 11, and when the flipping cover plate 42 is flipped to the horizontal state, the limiting protrusion 4211 extends into the limiting groove 131. In this way, by arranging the flipping cover plate 42, the wire management channel 100 is formed by the flipping cover plate 42, the groove wall surface of the bearing groove 11, and the memory partition plate 41 together, thereby ensuring the limiting reliability and guiding reliability of the wires.

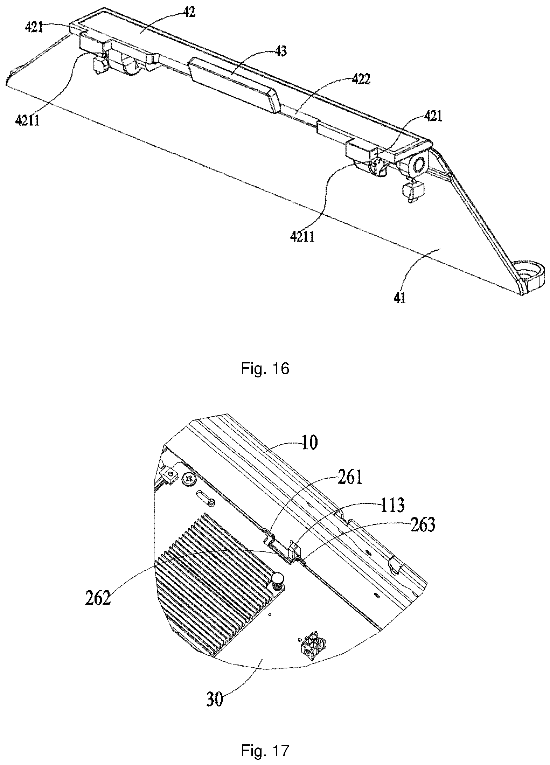

As shown in Fig. 16, an avoidance groove 422 is disposed in the edge of the side of the flipping cover plate 42 that is away from the memory partition plate 41; the memory module 40 further includes a handle structure 43; the handle structure 43 is disposed at the avoidance groove 422, and the handle structure 43 and the flipping cover plate 42 are arranged at an angle to each other; and the handle structure 43 obliquely extends upward along the groove wall surface of the bearing groove 11. In this way, through the arrangement of the handle structure 43, the operator conveniently adjusts a state of the flipping cover plate 42 by holding the handle structure 43.

It is to be noted that, in the present application, a torsional spring is further disposed at a pivoted junction between the flipping cover plate 42 and the memory partition plate 41; and the torsional spring is configured to provide an elastic force for the flipping cover plate 42 to flip to the horizontal state. In this way, it ensures that the flipping cover plate 42 is able to automatically return to its original position, thereby ensuring the wire management reliability of the wires.

The present application has the following beneficial effects.
1) The cooperation of rivets is reduced, and related features may be processed simply through the stamping forming process, thereby reducing costs. Compared to rivet and hardy hole structures, the contact area is large, such that the assembly efficiency is improved, and simple and convenient disassembly is achieved, thereby facilitating operations. Furthermore, by arranging an import structure, the mainboard tray is rapidly mounted on the chassis base, thereby improving the assembly efficiency. A flange structure is disposed in a special-shaped groove, sharp edges are prevented from coming into contact during mounting, causing wear and the falling of the iron filings, thereby ensuring the reliably and safety of a server.
2) The bump at the bottom of the chassis directly supports the CPU module, and the tray is disposed with the avoidance groove, such that the chassis is thicker, and the support force is stronger, the risk of stress-strain deformation of the mainboard is reduced. Moreover, the mainboard tray does not use Rubber as support, but uses the form of the mainboard stamping bumps as support, such that components with high insertion and removal force, such as a memory, are prevented from affecting the stress on the mainboard during insertion and removing, thereby ensuring system reliability.
3) A contact protruding point shielding structure is disposed on the sidewall of the chassis, and protruding points are in corresponding contact with the inner wall of the upper chassis cover, such that the structure is simple, costs are low, and a connection is formed between the chassis base and the upper chassis cover, thereby achieving the effect of electromagnetic shielding.
4) The flipping cover plate is designed above the memory partition plate and in lap joint with the bump on the sidewall of the chassis, so as to form the wire management channel, such that cables are prevented from shaking and being damaged during the running of a fan.
5) A bridge-shaped convex on the sidewall of the chassis is used instead of a PIN for limiting and stop, such that costs are reduced, and the riveting of the rivets is reduced.
6) The fixation of the mainboard and the tray realizes the reuse of holes to a maximum extent, achieving the effect of one hole for multiple uses, and the stud having a positioning effect is used. The positioning stud may support the M.2 bracket while achieving the effect of fixing the tray, thereby improving space utilization. The M.2 bracket also has a mainboard handle and has the effect of fixing an M.2 module, thereby achieving the full use of structural members. The wire management buckles are disposed on both sides of the bracket and configured to fix the cables on the mainboard, thereby fully improving the space utilization in the server. The support structure is disposed with the hand-turned screw, which is a rapidly-disassembled structure, convenient maintenance is achieved, and the maintenance of components below may be realized by unlocking the hand-turned screw.

It is to be noted that, terms used herein are intended to describe specific embodiments only and are not intended to limit specific embodiments according to the present application. As used herein, unless the context clearly indicates otherwise, a singular form is also intended to include a plural form. In addition, it is further understood that when the terms "including" and/or "comprising" are used in this specification, the terms indicate the presence of features, steps, operations, devices, components, and/or a combination thereof.

Unless specifically stated otherwise, the relative arrangement, numerical expressions, and numerical values of the components and steps set forth in these embodiments do not limit the scope of the present application. In addition, it is to be understood that the dimension of each portion shown in the drawings is not drawn to actual scale for ease of description. Techniques, methods, and devices known to those of ordinary skill in the relevant art may not be discussed in detail, but where appropriate, such techniques, methods, and devices should be considered as a part of the authorized specification. In all examples shown and discussed herein, any specific value should be construed as illustrative merely and not as limitations. Accordingly, other examples of the specific embodiments may have different values. It is to be noted that similar numbers and letters indicate similar items in the following drawings, so once a certain item is defined in one drawing, no further discussions are required for same in the subsequent drawings.

For ease of description, spatially relative terms such as "on...", "above...", "on an upper surface of...", "upper", and the like may be used here to describe the spatial position relationship between a device or feature and other devices or features as shown in the figure. It is to be understood that, the spatially relative terms are intended to cover different orientations in use or operation other than the orientation of the device described in the figure. For example, if the devices in the drawings are inverted, the devices described as "above" or "on" other devices or configurations will later be positioned as "below" or "under" other devices or configurations. Therefore, the specific term "above..." may include both orientations of "above..." and "below...". The device may also be positioned in other different ways (rotating 90 degrees or in other orientations), and the spatially relative descriptions used here are explained accordingly.

It is to be noted that, terms used herein are intended to describe specific embodiments only and are not intended to limit specific embodiments according to the present application. As used herein, unless the context clearly indicates otherwise, a singular form is also intended to include a plural form. In addition, it is further understood that when the terms "including" and/or "comprising" are used in this specification, the terms indicate the presence of features, steps, operations, devices, components, and/or a combination thereof.

It is to be noted that terms "first", "second" and the like in the description, claims and the above mentioned drawings of the present application are used for distinguishing similar objects rather than describing a specified sequence or a precedence order. It should be understood that the data used in such a way may be exchanged where appropriate, in order that the embodiments of the present application described here may be implemented in an order other than those illustrated or described herein.

The above are only the preferred embodiments of the present application and are not intended to limit the present application. For those skilled in the art, the present application may have various modifications and variations. Any modifications, equivalent replacements, improvements and the like made within the spirit and principle of the present application shall fall within the scope of protection of the present application.

## Claims

1. A server chassis module, comprising:
a chassis base (10), disposed with a bearing groove (11), wherein a bridge-shaped convex structure (12) is disposed on a groove bottom surface of the bearing groove (11); and
a mainboard tray (20), wherein a through hole structure (21) is disposed at a position of the mainboard tray (20) that is opposite to the bridge-shaped convex structure (12), and the bridge-shaped convex structure (12) is mated with the through hole structure (21) to connect the mainboard tray (20) and the chassis base (10).

2. The server chassis module as claimed in claim 1, wherein
in a direction from a front window to a rear window of the server chassis module, the bridge-shaped convex structure (12) comprises, in sequence, a first bridge-shaped convex segment (121), a second bridge-shaped convex segment (122), and a third bridge-shaped convex segment (123), which are connected to each other; the first bridge-shaped convex segment (121) extends upward obliquely, the second bridge-shaped convex segment (122) extends in a horizontal direction, and the third bridge-shaped convex segment (123) extends downward obliquely; a width of at least a portion of the second bridge-shaped convex segment (122) is greater than a width of the first bridge-shaped convex segment (121), and a width of at least the portion of the second bridge-shaped convex segment (122) is greater than a width of the third bridge-shaped convex segment (123);
in the direction from the front window to the rear window of the server chassis module, the through hole structure (21) comprises, in sequence, a first sub limiting hole segment (211), a second sub limiting hole segment (212), and a third sub limiting hole segment (213), which communicate with each other, and a width of the first sub limiting hole segment (211) is greater than a width of the third sub limiting hole segment (213); the second sub limiting hole segment (212) is conical; a large end side of the second sub limiting hole segment (212) communicates with the first sub limiting hole segment (211), and a small end side of the second sub limiting hole segment (212) communicates with the third sub limiting hole segment (213); and
a width of at least the portion of the second bridge-shaped convex segment (122) is less than the width of the first sub limiting hole segment (211), and a width of at least the portion of the second bridge-shaped convex segment (122) is greater than the width of the third sub limiting hole segment (213).

3. The server chassis module as claimed in claim 1, wherein
a first protruding structure (111) is also disposed on the groove bottom surface of the bearing groove (11); the first protruding structure (111) is disposed with a first assembly hole (1111); a second protruding structure (24) is disposed on the mainboard tray (20); the second protruding structure (24) is disposed with a second assembly hole (241); and the server chassis module further comprises a first fastening member, and the first fastening member sequentially passes through the second assembly hole (241) and the first assembly hole (1111), and connect the mainboard tray (20) and the chassis base (10).

4. The server chassis module as claimed in claim 1, wherein
a first limiting protrusion (112) is disposed on a groove wall surface of the bearing groove (11) in a protruding manner, and a side, facing toward the groove bottom surface of the bearing groove (11), of the first limiting protrusion (112) is disposed with a first stopping surface; and
a limiting flange (25) is disposed at an outer periphery of the mainboard tray (20) in a protruding manner, and in response to the mainboard tray (20) being mounted on the chassis base (10), the first stopping surface and the limiting flange (25) are in stopping fit to restrain the mainboard tray (20) from moving toward a side away from a groove bottom of the bearing groove (11).

5. The server chassis module as claimed in claim 4, wherein
the first stopping surface is flat; and/or
a plurality of first limiting protrusions (112) are disposed, at least two first limiting protrusions (112) among the plurality of first limiting protrusions (112) are respectively located at two opposite groove wall surfaces of the bearing groove (11), a plurality of limiting flanges (25) are disposed, at least two first limiting protrusions (112) among the plurality of limiting flanges (25) are respectively located on two opposite side edges of the mainboard tray (20), and the plurality of limiting flanges (25) correspond to the plurality of first limiting protrusions (112) on a one-to-one basis; and/or
in a direction from a front window to a rear window of the server chassis module, an extending length of the first limiting protrusion (112) is less than an extending length of the limiting flange (25).

6. The server chassis module as claimed in claim 1, wherein
a wire management protrusion (13) is disposed on a groove wall surface of the bearing groove (11), at least two wire management protrusions (13) are disposed, distances of the at least two wire management protrusions (13) from the groove bottom surface of the bearing groove (11) are equal, and the at least two wire management protrusions (13) are arranged at intervals in a direction from a front window to a rear window of the server chassis module; and
the server chassis module further comprises:
a mainboard body (30), disposed on the mainboard tray (20); and
a memory module (40), disposed on the mainboard body (30) and extending in the direction from the front window to the rear window of the server chassis module, wherein a memory partition plate (41) is disposed on the memory module (40), and a wire management channel (100) is formed between the memory partition plate (41) and the at least two wire management protrusions (13).

7. The server chassis module as claimed in claim 6, wherein
a first limiting protrusion (112) is disposed on a groove wall surface of the bearing groove (11) in a protruding manner, and a side, facing toward the groove bottom surface of the bearing groove (11), of the first limiting protrusion (112) is disposed with a first stopping surface;
a limiting flange (25) is disposed at an outer periphery of the mainboard tray (20) in a protruding manner, and in response to the mainboard tray (20) being mounted on the chassis base (10), the first stopping surface and the limiting flange (25) are in stopping fit to restrain the mainboard tray (20) from moving toward a side away from a groove bottom of the bearing groove (11);
a second limiting protrusion (113) is also disposed on the groove wall surface of the bearing groove (11) in a protruding manner, and a side, facing toward the rear window of the server chassis module, of the second limiting protrusion (113)is disposed with a second stopping surface;
a stop structure (26) is disposed at the outer periphery of the mainboard tray (20); in the direction from the front window to the rear window of the server chassis module, the stop structure (26) comprises, in sequence, a first stop flange (261), a groove structure (262), and a second stop flange (263), which are connected to each other; in response to the mainboard tray (20) being mounted on the chassis base (10), the second limiting protrusion (113) is located at the groove structure (262), and the second stopping surface and a groove wall surface of the groove structure (262) are in stopping fit to restrain the mainboard tray (20) from moving toward a side of the rear window of the server chassis module; and each of the at least two wire management protrusions (13) is located between the first limiting protrusion (112) and the second limiting protrusion (113), and a first distance H1 between each of the wire management protrusions (13) and the groove bottom surface of the bearing groove (11), a second distance H2 between the first limiting protrusion (112) and the groove bottom surface of the bearing groove (11), and a third distance H3 between the second limiting protrusion (113) and the groove bottom surface of the bearing groove (11) meet: H1>H2, and H1>H3.

8. The server chassis module as claimed in claim 1, wherein a first support bump (14) is disposed on the groove bottom surface of the bearing groove (11) in a protruding manner; a first avoidance through hole (27) is disposed at a position of the mainboard tray (20) that is opposite to the first support bump (14) to avoid the first support bump (14); the server chassis module further comprises a mainboard body (30), and the mainboard body (30) is disposed on the mainboard tray (20); a CPU module (50) is also disposed on the mainboard tray (20); and the first support bump (14) is configured to provide support for the CPU module (50).

9. The server chassis module as claimed in claim 1,
wherein the server chassis module further comprises:
an upper chassis cover, disposed at a notch of the bearing groove (11) and forming an accommodating cavity with the bearing groove (11); wherein
a shielding protrusion (15) is disposed on a sidewall surface of the chassis base (10) in a protruding manner, and the shielding protrusion (15) is in contact with an inner wall surface of the upper chassis cover to connect the chassis base (10) and the upper chassis cover.

10. The server chassis module as claimed in any one of claims 1 to 9, wherein
a third protruding structure (28) is disposed on the mainboard tray (20), and the third protruding structure (28) is disposed with a third assembly hole (281); and
the server chassis module further comprises:
the mainboard body (30), wherein a fourth assembly hole is disposed at a position of the mainboard body (30) that is opposite to the third protruding structure (28); and
a second fastening member, sequentially passing through the fourth assembly hole and the third assembly hole (281) to connect the mainboard body (30) and the mainboard tray (20).

11. The server chassis module as claimed in claim 10, wherein
a plurality of second support bumps (29) are disposed on the mainboard tray (20) in a protruding manner; and the plurality of second support bumps (29) are arranged at intervals in length and width directions of the mainboard tray (20) to provide support for the mainboard body (30).

12. The server chassis module as claimed in claim 11, wherein
at least two positioning posts (210) are disposed on the mainboard tray (20) in a protruding manner, and the mainboard body (30) is disposed with at least two sliding positioning holes (31); the number of the at least two sliding positioning holes (31) is the same as the number of the at least two positioning posts (210), and the at least two sliding positioning holes correspond to and are mated with the at least two positioning posts on a one-to-one basis; and the mainboard body (30) is mounted on the mainboard tray (20) through cooperative positioning of the at least two sliding positioning holes (31) and the at least two positioning posts (210).

13. The server chassis module as claimed in claim 12, wherein a height of the at least two positioning posts (210) is greater than a height of the plurality of second support bump (29).

14. The server chassis module as claimed in claim 10,
wherein the server chassis module further comprises:
a support bracket (60), disposed on the mainboard body (30), wherein a side of the support bracket (60) that faces toward the front window of the server chassis module has a support region, and the support region is configured to support a server module (70);
a first positioning stud (32) is disposed on the mainboard body (30) in a protruding manner, and the first positioning stud (32) has a first internal thread structure; and
a first assembly lug (61) is disposed on a side of the support bracket (60) that faces toward the rear window of the server chassis module, the first assembly lug (61) extends in a horizontal direction, and a second avoidance through hole is disposed on the first assembly lug (61); and
the server chassis module further comprises:
a hand-turned screw (80), having a first external thread structure, passing through the second avoidance through hole, and being in threaded cooperation with the first internal thread structure.

15. The server chassis module as claimed in claim 14, wherein
a second assembly lug (62) is disposed on a side of the support bracket (60) that faces toward the front window of the server chassis module, the second assembly lug (62) extends in the horizontal direction, and a third avoidance through hole is disposed on the second assembly lug (62);
a fourth protruding structure (220) is disposed on the mainboard tray (20), the fourth protruding structure (220) is disposed with a fifth assembly hole (2201), and a hole wall surface of the fifth assembly hole (2201) has a second internal thread structure; and
a sixth assembly hole is disposed at a position of the mainboard body (30) that is opposite to the fifth assembly hole (2201); and
the server chassis module further comprises:
a second positioning stud (90), wherein in a direction from a groove bottom of the bearing groove to a notch of the bearing groove (11), the second positioning stud (90) comprises, in sequence, a first shaft segment (91), a second shaft segment (92), and a third shaft segment (93), which are connected to each other; at least a portion of the first shaft segment (91) has a second external thread structure that is configured to be mated with the second internal thread structure;
a diameter of the second shaft segment (92) is greater than a diameter of the first shaft segment (91), a first stopping ring surface is formed at a junction of the first shaft segment and the second shaft segment; the first shaft segment (91) passes through the sixth assembly hole and extends into the fifth assembly hole (2201) such that the first stopping ring surface abuts against the mainboard body (30);
the diameter of the second shaft segment (92) is greater than a diameter of the third shaft segment (93), a second stopping ring surface is formed at a junction of the second shaft segment and the third shaft segment; and the third shaft segment (93) passes through the third avoidance through hole and the second stopping ring surface abuts against a surface of a side of the second assembly lug (62) that faces toward the mainboard body (30).

16. The server chassis module as claimed in claim 15, wherein
a limiting boss (63) is also disposed on the second assembly lug (62), the limiting boss (63) is disposed with a fourth avoidance through hole (631), and the fourth avoidance through hole (631) and the third avoidance through hole are concentrically arranged; and
the third shaft segment (93) passes through the third avoidance through hole and extends into the fourth avoidance through hole (631).

17. The server chassis module as claimed in claim 14, wherein an avoidance notch (64) is disposed on a side of the support bracket (60) that faces toward the mainboard body (30); and at least two handle grooves (641) are disposed at the avoidance notch (64).

18. The server chassis module as claimed in claim 14, wherein a wire management buckle is disposed on two sides of the support bracket (60) in a width direction of the chassis base (10); a first end of the wire management buckle (65) is connected to a sidewall surface of the support bracket (60); and a second end of the wire management buckle (65) first extends in the horizontal direction for a first preset distance, then obliquely extends upward in a direction away from the support bracket (60) for a second preset distance, and continuously obliquely extends upward in a direction close to the support bracket (60) for a third preset distance.

19. The server chassis module as claimed in claim 1, wherein the mainboard tray (20) comprises:
a tray body (22), wherein the through hole structure (21) is a limiting hole that is disposed on the tray body (22); and
a guiding flange (23), wherein the guiding flange (23) is disposed at a hole periphery of at least a portion of the limiting hole, and the guiding flange (23) extends in a direction away from the tray body (22).

20. The server chassis module as claimed in claim 1, wherein
a second limiting protrusion (113) is disposed on a groove wall surface of the bearing groove (11) in a protruding manner, and a side of the second limiting protrusion (113) that faces toward a rear window of the server chassis module has a second stopping surface;
a stop structure (26) is disposed at an outer periphery of the mainboard tray (20); in a direction from a front window to the rear window of the server chassis module, the stop structure (26) comprises, in sequence, a first stop flange (261), a groove structure (262), and a second stop flange (263), which are connected to each other; and after the mainboard tray (20) is mounted on the chassis base (10), the second limiting protrusion (113) is located at the groove structure (262), and the second stopping surface and a groove wall surface of the groove structure (262) are in stopping fit to restrain the mainboard tray (20) from moving toward a side of the rear window of the server chassis module.

21. The server chassis module as claimed in claim 7 or 20, wherein
the second stopping surface is flat; and/or
in the direction from the front window to the rear window of the server chassis module, an extending length of the second limiting protrusion (113) is less than an extending length of the groove structure (262).

22. The server chassis module as claimed in claim 1, wherein
wire management protrusions (13) are disposed on a groove wall surface of the bearing groove (11), at least two wire management protrusions (13) are disposed, distances of the at least two wire management protrusions (13) from the groove bottom surface of the bearing groove (11) are equal, and the at least two wire management protrusions (13) are arranged at intervals in a direction from a front window to a rear window of the server chassis module; and
a limiting groove (131) is disposed in a surface of a side of each of the wire management protrusions (13) that is away from the groove bottom surface of the bearing groove (11);
the server chassis module further comprises:
a mainboard body (30), disposed on the mainboard tray (20); and
a memory module (40), disposed on the mainboard body (30) and extending in the direction from the front window to the rear window of the server chassis module, wherein the memory module (40) has a memory partition plate (41), wherein
the memory module (40) further comprises:
a flipping cover plate (42), pivotally connected to a side of the memory partition plate (41) that is away from the mainboard body (30), wherein the flipping cover plate (42) is at least flipped to a horizontal state such that the flipping cover plate (42), the memory partition plate (41), and the groove wall surface of the bearing groove (11) form a wire management channel (100); and
a lug structure (421) is disposed on an edge of a side of the flipping cover plate (42) that is away from the memory partition plate (41), the lug structure (421) is disposed with a limiting protrusion (4211) in a protruding manner on a side facing toward the groove bottom surface of the bearing groove (11), and when the flipping cover plate (42) is flipped to the horizontal state, the limiting protrusion (4211) extends into the limiting groove (131).

23. The server chassis module as claimed in claim 22, wherein
an avoidance groove (422) is disposed in the edge of the side of the flipping cover plate (42) that is away from the memory partition plate (41); the memory module (40) further comprises a handle structure (43); the handle structure (43) is disposed at the avoidance groove (422), and the handle structure (43) and the flipping cover plate (42) are arranged at an angle to each other; and the handle structure (43) obliquely extends upward along the groove wall surface of the bearing groove (11).

24. The server chassis module as claimed in claim 22, wherein a torsional spring is further disposed at a pivoted junction between the flipping cover plate (42) and the memory partition plate (41); and the torsional spring is configured to provide an elastic force for the flipping cover plate (42) to flip to the horizontal state.
